(19) Europäisches Patentamt / European Patent Office / Office européen des brevets

(11) **EP 3 047 708 B1**

(12) **EUROPEAN PATENT SPECIFICATION**

(45) Date of publication and mention
of the grant of the patent:
**27.03.2024   Bulletin 2024/13**

(21) Application number: **14789341.6**

(22) Date of filing: **18.09.2014**

(51) International Patent Classification (IPC):
$H05K\ 3/32^{(2006.01)}$       $C09J\ 9/02^{(2006.01)}$
$H01R\ 4/04^{(2006.01)}$       $H01L\ 23/00^{(2006.01)}$
$H05K\ 1/18^{(2006.01)}$       $H05K\ 3/12^{(2006.01)}$
$H05K\ 1/11^{(2006.01)}$

(52) Cooperative Patent Classification (CPC):
**H05K 1/111; C09J 9/02; H05K 1/189; H05K 3/125;
H05K 3/1275; H05K 3/32; H05K 3/321;**
H05K 2201/0329; H05K 2201/10636;
H05K 2201/10674; H05K 2201/10727; Y02P 70/50

(86) International application number:
**PCT/GB2014/052832**

(87) International publication number:
**WO 2015/040397 (26.03.2015 Gazette 2015/12)**

(54) **CIRCUIT BOARD ASSEMBLY**

LEITERPLATTENANORDNUNG

ENSEMBLE CARTE À CIRCUIT IMPRIMÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.09.2013   GB 201316539**

(43) Date of publication of application:
**27.07.2016   Bulletin 2016/30**

(73) Proprietor: **Novalia Ltd
Cambridge
Cambridgeshire CB5 8RE (GB)**

(72) Inventor: **STONE, Kate
Impington Cambridge,
Cambridgeshire CB24 9NP (GB)**

(74) Representative: **Piotrowicz, Pawel Jan Andrzej et
al
Venner Shipley LLP
Byron House
Cambridge Business Park
Cowley Road
Cambridge CB4 0WZ (GB)**

(56) References cited:
**WO-A1-02/061831     US-B1- 6 396 712**

## Description

### Field of the Invention

The present invention relates to a circuit board assembly.

### Background

Electronic components are increasingly being incorporated into printed articles, such as books, posters and greeting cards, to allow printed articles to become more interactive. Examples of interactive printed articles are described in GB 2 464 537 A, WO 2004 077286 A, WO 2007 035115 A and DE 1993 4312672 A.

Interconnections between conventional circuit boards, discrete devices and/or packaged devices can be made using solder re-flow pastes in conjunction with solder resist layers. An example of such an arrangement is described in US 2005/0046023 A1. However, solder re-flow processing is not suited to integrating electronic components into printed articles.

Another method of interconnecting conventional circuit boards, discrete devices and/or packaged devices is to use anisotropic conductive films/layers comprising conductive particles embedded in a non-conductive medium. Examples of such arrangements are described in US 5 629 838 A, WO 2008/065997 A$_1$, EP 1 702 968 A1 and EP 0 260 141 A2.

Other methods interconnecting conventional circuit boards, discrete devices and/or packaged devices have been described. For example, DE 29 02 002 A1 describes monolithically integrating stacks of silicon wafers using layers of conductive adhesive. WO 99/41784 A1 describes interconnecting conventional circuit boards, discrete devices and/or packaged devices using layers of half-conductive materials. Half-conductive liquid/paste/foil layers are described which comprise a mixture of conductive filler particles embedded in a high resistance base material.

Conventionally, discrete devices (such as capacitors) and packaged devices (such as microcontrollers) are mounted to a printed wiring board and the printed wiring board is mounted to or inserted into the printed article, such as a poster or greeting card. However, devices can be directly connected to conductive tracks using conductive glue or tape. Examples of such arrangements are described in GB 2490 384 A and GB 2 494 223 A.

WO 02/061831 A1 describes a chip which is coupled to a substrate. The chip has at least two bond pads arranged on the same side at a distance from each other, and the substrate has at least two contact bond pads arranged on the same side. An isotropic adhesive is applied to the side of the chips where the bond pads are arranged, or to the side of the substrate where the contact bond pads are arranged. The chip and the substrate are aligned in relation to each other so that the bond pads of the chip and the contact bond pads of the substrates are opposite each other. After the coupling, which occurs by bringing together the chip and the substrate, a totally flat isotropic coupling layer of adhesive is formed.

### Summary

According to a first aspect of the present invention there is provided a circuit board assembly comprising a circuit board which comprises a substrate supporting a plurality of tracks, each track including a first end providing a contact land and a second end having an enlarged region which provides a capacitive touch switch. The circuit board assembly also includes a microcontroller which comprises a plurality of contact pads and which is mounted on the circuit board such that the contact pads are aligned with the contact lands. The microcontroller is configured to receive user input via the capacitive touch switches. The circuit board assembly comprises an interconnect layer which has a sheet resistance, $R_S$, of at least 0.5 MΩ/sq and which is disposed between the microcontroller and the circuit board, and which is arranged to provide electrical connections between the contact lands and corresponding contact pads. A through resistance, $R_T$, of the connection between the contact lands and corresponding contact pads is less than the sheet resistance. A resistance between adjacent contact pads of the plurality of contact pads or between adjacent contact lands of the plurality of contact lands is greater than or equal to the sheet resistance.

Thus, a single interconnect layer can be used to connect pairs of contact pads and lands in parallel thereby making the assembly easier to fabricate.

The interconnect layer may have a sheet resistance, $R_S$, of at least 1 MΩ/sq, at least 2 MΩ/sq or at least 3 MΩ/sq. The interconnect layer may have a sheet resistance, $R_S$, of no more than 1 GΩ/sq, no more than 100 MΩ/sq, no more than 10 MΩ/sq or no more than 10 MΩ/sq.

The separation between adjacent contact pads or contact lands may be greater than or equal to a width of each contact pad or contact land. Thus, the resistance between adjacent contact pads (or lands) is the same as, or more than, the sheet resistance, $R_S$.

The interconnect layer may comprise a homogeneously conductive material. This can simplify production because the distribution of conductive particles within the interconnect layer material/precursor does not need to be controlled during storage and/or application of the interconnect layer.

The ratio of the sheet resistance, $R_S$, to the contact resistance, $R_C$, between a contact pad and the corresponding contact land may be at least 2500:1, at least 10 000:1 or at least 30 000:1. A high resistance ratio provides robustness against signal cross-talk between adjacent pairs of contact pads and contact lands. Thus, a high resistance ratio enables connection of sensitive analogue components via the interconnect layer.

The interconnect layer may have a thickness, $t$, of at least 100 nm, at least 200 nm or at least 500 nm. The interconnect layer may have a thickness, $t$, of no more than 100 $\mu$m, no more than 50 $\mu$m or no more than 20 $\mu$m.

The interconnect layer may have a thickness, $t$, which is between $0.1.t_r$ and $10.t_r$, where:

$$t_r = \mathrm{sqrt}\,(R_C.A/R_S)$$

where $R_c$ is contact resistance and $A$ is area of the contact land and/or contact pad.

The interconnect material may comprises a conductive polymer.

The circuit board assembly comprises more than one interconnect layer in the form of separate co-planar pads.

The microcontroller may comprise a discrete component. The microcontroller may be packaged, in other words, the microcontroller may be a package. The microcontroller may comprise a flat package. The microcontroller may comprise a flat no-lead package. The package may be a quad flat package. The microcontroller may comprise a printed circuit board.

The substrate may be flexible, for example, capable of being bent by more than 10°. The substrate may comprise a layer of a fibre-based material, such as paper, card or cardboard. The layer may consist mainly of the fibre-based material. Fibre-based material may comprise recycled material.

The substrate may comprise a layer of a plastics material. For example, the substrate may comprise polyethylene terephthalate (PET), polypropylene (PP) or polyethylene naphthalate (PEN).

The substrate may comprise a laminate of at least two layers. For example, the substrate may comprise a layer of fibre-based material covered with a layer of plastic or sandwiched between two layers of plastic.

The lands may comprise conductive ink, such as silver or carbon. The lands may comprise foil. The lands may have a sheet resistance of no more than 1 k$\Omega$/sq, no more than 100 $\Omega$/sq, no more than 10 $\Omega$/sq or no more than 1 $\Omega$/sq. The lands may comprise ends of conductive tracks.

The circuit board assembly may comprise a printed article or part of a printed article supporting printed indicia, such as text and/or images.

The circuit board assembly may comprise a printed article or a part (such as a cover) of printed article. The printed article may be a greeting card, poster, book, product packaging, point-of-sale display, map or pamphlet.

According to a second aspect of the present invention there is provided a method of manufacturing a circuit board assembly. The method comprises applying an interconnect layer which has a sheet resistance, $R_S$, of at least 0.5 M$\Omega$/sq to a microcontroller comprising a plurality of contact pads and/or to a circuit board comprising a substrate supporting a plurality of tracks, each track including a first end providing a contact land and a second end having an enlarged region which provides a capacitive touch switch. The method comprises mounting the microcontroller on the circuit board such that the contact pads are aligned with the contact lands and such that the interconnect layer provide electrical connections between the contact lands and corresponding contact pads. The microcontroller is configured to receive user input via the capacitive touch switches. A through resistance, $R_T$, of the connection between the contact lands and corresponding contact pads is less than the sheet resistance. A resistance between adjacent contact pads of the plurality of contact pads or between adjacent contact lands of the plurality of contact lands is greater than or equal to the sheet resistance.

Applying the interconnect layer may comprise printing interconnect material.

**Brief Description of the Drawings**

Certain embodiments of the present invention will now be described, by way of example, with reference to the accompanying drawings, in which:

Figure 1 is a perspective view of an article including a substrate, a device mounted on the circuit board using a interconnect layer;
Figure 2 is a plan view of a circuit board;
Figure 3a is a bottom view a device;
Figure 3b is a side view of a device;
Figures 4a, 4b and 4c show first, second and third patterns for the interconnect layer; and
Figure 5 schematically shows an arrangement of adjacent contact lands and a contact pad.

**Detailed Description of Certain Embodiments**

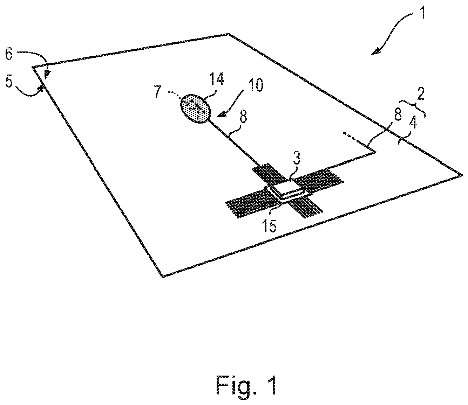

Referring to Figure 1, a printed article 1 is shown which includes a circuit board 2 and a device 3 mounted to the circuit board 2.

In Figure 1, only one device 3 is shown for sake of clarity. However, typically several devices are mounted to the circuit board 2 to provide an electronic system which can receive user input, for example, via one or more capacitive touch switches and/or via a wireless network interface and provide output, for example, in the form of light and/or sound signals, and/or via a user device (such as a smart phone) using the wireless network interface.

The circuit board 2 comprises a substrate 4, for example formed of cardboard, having first and second faces 5, 6. The first face 5 of the substrate 4 supports printed indicia 7. The second face 6 of the substrate 4 supports electrically-conductive tracks 8.

The tracks 8 comprise conductive silver ink and are formed by printing using a printing process, such a lithographic printing. However, the tracks 8 may comprise conductive carbon ink which may be formed by printing, or metal foil which may be formed by stamping or patterning and etching a foil film.

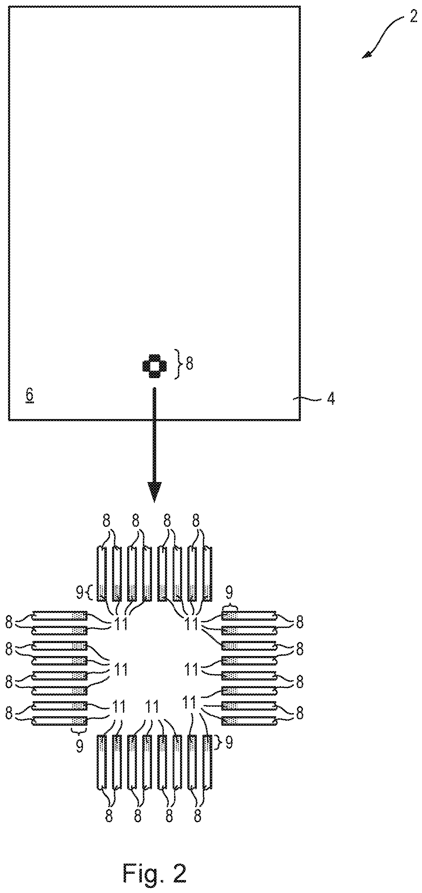

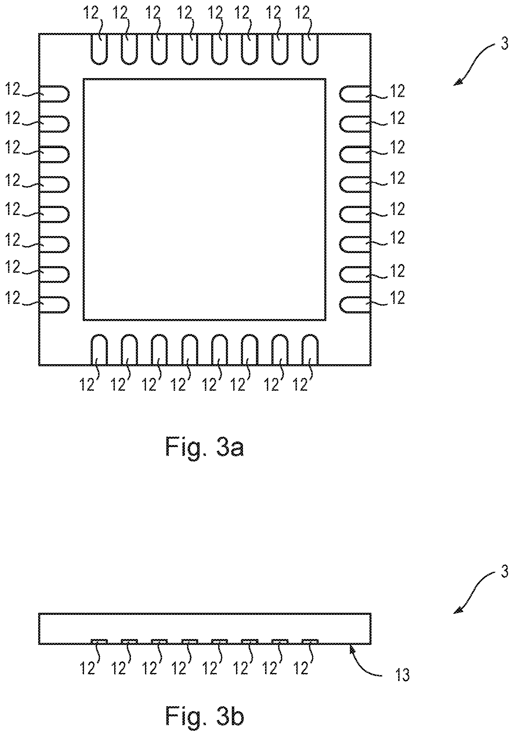

Referring also to Figures 2, 3a and 3b, each track 8 includes first and second ends 9, 10. At least some of first ends 9 of the tracks 8 provide (or are provided with) contact lands 11 (shown shaded in Figure 2) for connecting to corresponding contact pads 12 on an underside surface 13 of the device 3. At least one of the second ends 10 of the tracks 8 has an enlarged region 14 (for example having an area of 1 cm$^2$ to 100 cm$^2$) which provides a capacitive touch switch.

The circuit board 2 need not be a conventional printed circuit board (PCB). The circuit board 2 may have (and typically has) the appearance of a traditional printed article, such as poster, map, point-of-sale display, book or magazine.

Referring also to Figure 3, the device 3 is a microcontroller in the form of a flat no-lead package. However, in embodiments which are not part of the claimed invention the device 3 can be an unpackaged device, e.g. a bare die (such as an LED), a discrete component (such as a resistor) or a PCB which supports one or more devices. The device(s) may include a sensor (such as a microphone), an actuator (such as a piezo speaker), coin cell holder or wireless network interface module (such as Bluetooth (RTM)).

Referring still to Figure 1, the device 3 is mounted to the circuit board 2 using a thin interconnect layer 15 (which may also be referred to as a "pad" or "strip") which comprises a conductive, but not highly-conductive material, such as lightly-doped conducting polymer, having a sheet resistance, $R_S$, of about 3 MΩ/sq. The interconnect layer 15 is in direct contact the circuit board lands 9 and device pads 12. The interconnect layer 15 preferably functions as an adhesive.

As will be explained later, the thickness of the interconnect layer 15 is chosen to minimise sufficiently leakage between adjacent pads 12, but provide sufficient current between a land 11 and a corresponding pad 12.

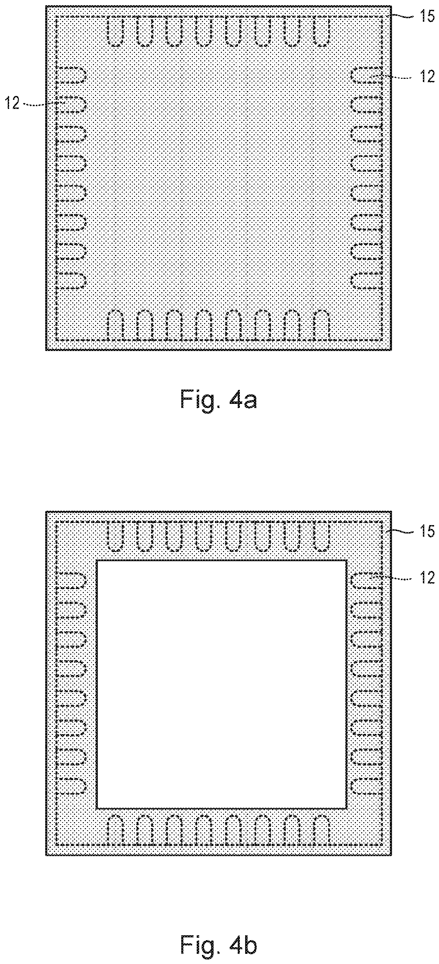

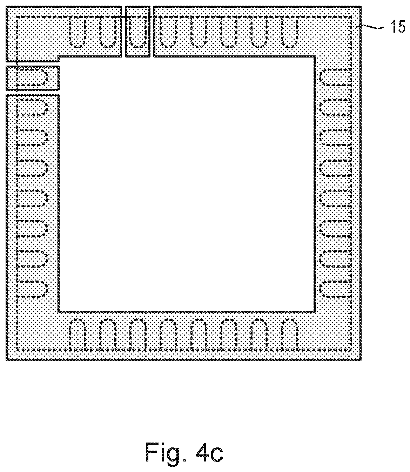

Referring to Figures 4a, 4b and 4c different interconnect layer patterns are shown.

Figures 4a, 4b and 4c shows the outlines of the device 3 and pads 12 in chain to illustrate position of the interconnect layer 15 relative to the device 3.

As shown in Figure 4a, the interconnect layer 15 may take the form of a solid block of material and be approximately co-extensive with the device 3. As shown in Figure 4b, the interconnect layer 15 may take the form of annulus. As shown in Figure 4b, more than one interconnect layer 15 can be used, for example, to isolate pads 12 which are held at high voltages.

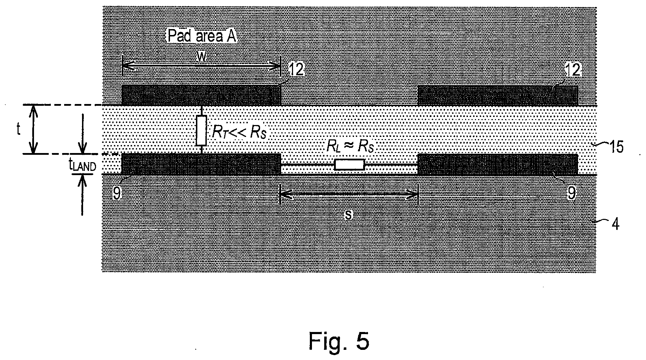

Referring to Figures 5 and 6, a non-limiting explanation of the underlying principles of operation will now be given.

The interconnect layer 15 comprises a material which is conductive, but which is generally less conductive than most metals, which tend to have a bulk resistivity, $\rho$, of about $10^{-8}$ Ωm. For example, the interconnect layer 15 may comprise a material having a bulk resistivity, $\rho$, which has an order of magnitude in the range of 0.01 to 100 Ωm.

The interconnect layer material is preferably homogeneously conductive, i.e. preferably does not comprise particles of relatively high conductivity embedded in a matrix of relatively low conductivity.

The thickness, $t$, of the interconnect layer 15 is chosen so that it has a poor sheet resistance. For example, the interconnect layer 15 may have a sheet resistance, $R_S$, which has an order of magnitude of 0.1 MΩ/sq, 1 MΩ/sq or 10 MΩ/sq.

The invention is based on the insight that the resistance, $R$, between two points in a conductive film is the about the same as the sheet resistance, $R_S$, provided that the points are not too close to the edge or the points effectively map out a square in the material, i.e. the points are found at corners of a block or strip of material that is wide as it is long.

Thus, by making the thickness, $t$, of the interconnect layer 15 sufficiently small so that the aspect ratio of the block of material between terminals that are to be connected is small, the resistance (herein referred to as the "through resistance" $R_T$) is relatively small, i.e. several orders of magnitude lower than the sheet resistance, $R_S$. However, for adjacent terminals which are not intended to be connected, the resistance is relatively large, i.e. approximately equal to the sheet resistance, $R_S$.

The distance between adjacent pads 9 (or lands 12) can be equal to, or more than, the width of each pad 9 (or land 12). Thus, the resistance between adjacent pads 9 (or lands 12) is the same, as or more than, the sheet resistance, $R_S$.

The material and thickness can be chosen as follows:
First, a sheet resistance, $R_S$, is chosen.

The sheet resistance, $R_S$, is chosen by considering a minimum resistance required between two terminals. For example, a standby current may be used which lies in a range between about 1 $\mu$A and about 10 $\mu$A. If these currents are driven by a voltage of about 3 V, then resistance between power pins should be 3 M$\Omega$ or less. Thus, a sheet resistance, $R_S$, of 3 M$\Omega$/sq is chosen.

Secondly, a through resistance, $R_T$, is chosen.

For example, a microcontroller can typically supply around 25 to 30 mA. For 3 V operation, this gives a through resistance, $R_T$, of 100 $\Omega$.

In this example, the ratio of the sheet resistance, $R_S$, to the through resistance, $R_T$, is 30 000:1. For 3 V operation of a controller using standby currents in the range of 1 $\mu$A to 10 $\mu$A and supply currents in the range 25 to 30 mA, the minimum ratio of the sheet resistance, $R_S$, to the through resistance, $R_T$, is 2500:1. Larger ratios than 30 000:1 can be used provided the value of the through resistance, $R_T$, can be kept within the desired range.

An estimate of the thickness, $t$, of the interconnect layer 15 as a function of the through resistance, $R_T$, can be estimated using equation 1 below, namely:

$$t = \mathrm{sqrt}(R_T.A/R_S) \qquad\qquad (1)$$

where $A$ is the area of a pad 12.

Thus, the thickness, $t$, depends on the area of the pad 12. In particular, if the pad 12 is smaller, then the interconnect layer 15 should be thinner.

For example, if a bare die has a pad length, $l$, and a pad width, $\omega$, of 100 $\mu$m, then the pad area, A, is 0.01 mm$^2$. If sheet resistance is $R_S$ = 3 M$\Omega$/sq and the through resistance is $R_T$ = 100 $\Omega$, then the interconnect layer thickness, $t$, should be no more than 0.58 $\mu$m.

In another example, if the a printed circuit board has a pad length, $l$, and pad width, $\omega$, of 3 mm, then the pad area, A, is 9 mm. If sheet resistance is $R_S$ = 3 M$\Omega$/sq and the through resistance is $R_T$ = 100 $\Omega$, then the interconnect layer thickness, $t$, should be no more than 17 $\mu$m.

Having found the thickness, $t$, of the interconnect layer 15, then the resistivity, $\rho$, of the material can be found using equation 2 below, namely:

$$\rho = R_S . t \qquad\qquad (1)$$

where $R_S$ is sheet resistance of the interconnect layer 15 and $t$ is thickness of the layer.

A suitable material can then be found which has the desired resistivity. For instance, a conductive polymer can be found which has the approximate desired resistivity and can be doped to obtain a more precise value of resistivity.

For example, in the case of the bare die, the desired resistivity, $\rho$, is 1.7 $\Omega$m and in the case of the PCB, the desired resistivity, $\rho$, is 51 $\Omega$m. For example, PEDOT:PSS doped with DMSO and isopropanol has the desired resistivity.

The interconnect layer 15 can be printed using a printing process, such as inkjet printing or lithographic printing.

Test samples can be fabricated and measured using two- or four-probe resistance measurements to find suitable thicknesses and materials for the interconnect layer 15.

When sensitive analogue devices such as resistive or capacitive touch switches are connected via the interconnect layer 15, the ratio of the sheet resistance, $R_S$, to the through resistance, $R_T$, may be at least 2500:1 and is preferably as large as possible. Digital electronic components can tolerate lower resistance ratios because digital electronics recognise high/low inputs within a range of voltages. By contrast, absolute voltage values are used for analogue components. For example, in a case in which several resistive or capacitive touch switches are connected via the interconnect layer 15, the resistance ratio should preferably be made as large as is practical. When the resistance ratio is sufficiently large, the possibility of erroneous touch switch actuation caused by signal crosstalk between adjacent contact lands or contact pads is reduced. Using a high resistance ratio can also allow the triggering threshold for actuation of user input touch switch(es) to be kept low so that a user may easily actuate the touch switch(es).

It will be appreciated that many modifications may be made to the embodiments hereinbefore described.

A interconnect layer material can be chosen which wets the pad and/or lands, but not the substrate or rest of the device.

**Claims**

1.  A circuit board assembly comprising:

    a circuit board (2) comprising a substrate (4) supporting a plurality of tracks (8), each track including a first end (9) providing a contact land (11) and a second end (10) having an enlarged region (14) which provides a capacitive touch switch;
    a microcontroller (3) comprising a plurality of contact pads (12) which is mounted on the circuit board such that the contact pads are aligned with the contact lands, the microcontroller configured to receive user input via the capacitive touch switches; and
    an interconnect layer (15) which has a sheet resistance, $R_S$, of at least 0.5 M$\Omega$/sq and which is disposed between the microcontroller and the circuit board and which is arranged to provide electrical connections between the contact lands and corresponding contact pads;
    wherein a through resistance, $R_T$, of the connection between the contact lands and corresponding contact pads is less than the sheet resistance, $R_S$; and
    wherein a resistance between adjacent contact pads of the plurality of contact pads or between adjacent contact lands of the plurality of contact lands is greater than or equal to the sheet resistance.

2.  A circuit board assembly according to claim 1, wherein the separation between adjacent contact pads (12) or contact lands (9) is greater than or equal to a width of each contact pad or contact land.

3.  A circuit board assembly according to claim 1 or 2, wherein the interconnect layer (15) comprises a homogeneously conductive material, such as a conductive polymer.

4.  A circuit board assembly according to any preceding claim, wherein the ratio of the sheet resistance, $R_S$, to the contact resistance, $R_C$, between a contact pad (12) and the corresponding contact land (9) is at least 2500:1, at least 10 000:1 or at least 30 000:1.

5.  A circuit board assembly according to any preceding claim, wherein the thickness, $t$, is between $0.1.t_r$ and $10.t_r$, where:

$$t_r = \mathrm{sqrt}\,(R_C.A/R_S)$$

    where $R_C$ is contact resistance and A is area of the contact land (9) and/or contact pad (12).

6.  A circuit board assembly according to any preceding claim, wherein the interconnect layer (15) is patterned into at least two separate co-planar pads.

7.  A circuit board assembly according to any one of claims 1 to 6, wherein the microcontroller (3) comprises a flat package, such as flat no-lead package.

8.  A circuit board assembly according to any one of claims 1 to 6, wherein the microcontroller comprises a printed circuit board.

9.  A circuit board assembly according to any preceding claim, wherein the substrate (4) is flexible.

10. A circuit board assembly according to any preceding claim, wherein the substrate (4) comprises a layer of a fibre-based material, such paper, card or cardboard, preferably wherein the layer consists mainly of the fibre-based material.

11. A circuit board assembly according to any preceding claim, wherein the substrate (4) comprises a layer of a plastics material and/or the substrate comprises a laminate of at least two layers.

12. A circuit board assembly according to any preceding claim, wherein the circuit board assembly comprises a printed article or part of a printed article supporting printed indicia.

13. A method of manufacturing a circuit board assembly according to claim 1, the method comprising:

applying an interconnect layer (15) which has a sheet resistance, $R_S$, of at least 0.5 MΩ/sq to a microcontroller (3) comprising a plurality of contact pads (12) and/or to a circuit board (2) comprising a substrate (4) supporting a plurality of tracks (8), each track including a first end (9) providing a contact land (11) and a second end (10) having an enlarged region (14) which provides a capacitive touch switch; and

mounting the microcontroller onto a circuit board such that the contact pads are aligned with the contact lands and such that the interconnect layer provides electrical connections between the contact lands and corresponding contact pads, wherein the microcontroller is configured to receive user input via the capacitive touch switches; wherein a through resistance, $R_T$, of the connection between the contact lands and corresponding contact pads is less than the sheet resistance $R_S$; and

wherein a resistance between adjacent contact pads of the plurality of contact pads or between adjacent contact lands of the plurality of contact lands is greater than or equal to the sheet resistance.

**Patentansprüche**

1. Leiterplattenanordnung, umfassend:

   eine Leiterplatte (2), die ein Substrat (4) umfasst, das eine Vielzahl von Bahnen (8) trägt, wobei jede Bahn ein erstes Ende (9), das eine Kontaktfläche (11) bereitstellt, und ein zweites Ende (10) mit einer vergrößerten Region (14), die einen kapazitiven Berührungsschalter bereitstellt, beinhaltet;
   eine Mikrosteuerung (3), die eine Vielzahl von Kontaktpads (12) umfasst, die an der Leiterplatte montiert ist, sodass die Kontaktpads mit den Kontaktflächen ausgerichtet sind, wobei die Mikrosteuerung konfiguriert ist, um Benutzereingabe über die kapazitiven Berührungsschalter zu empfangen; und
   eine Verbindungslage (15), die einen Schichtwiderstand, Rs, von zumindest 0,5 MΩ/sq aufweist und die zwischen der Mikrosteuerung und der Leiterplatte vorgesehen ist und die angeordnet ist, um elektrische Verbindungen zwischen den Kontaktflächen und entsprechenden Kontaktpads bereitzustellen;
   wobei ein Durchgangswiderstand, $R_T$, der Verbindung zwischen den Kontaktflächen und entsprechenden Kontaktpads geringer als der Schichtwiderstand, Rs, ist; und
   wobei ein Widerstand zwischen benachbarten Kontaktpads aus der Vielzahl von Kontaktpads oder zwischen benachbarten Kontaktflächen aus der Vielzahl von Kontaktflächen größer als der oder gleich dem Schichtwiderstand ist.

2. Leiterplattenanordnung nach Anspruch 1, wobei die Trennung zwischen benachbarten Kontaktpads (12) oder Kontaktflächen (9) größer als eine oder gleich einer Breite jedes Kontaktpads oder jeder Kontaktfläche ist.

3. Leiterplattenanordnung nach Anspruch 1 oder 2, wobei die Verbindungslage (15) ein homogen leitendes Material wie ein leitendes Polymer umfasst.

4. Leiterplattenanordnung nach einem vorhergehenden Anspruch, wobei das Verhältnis des Schichtwiderstands, $R_S$, zu dem Kontaktwiderstand, $R_C$, zwischen einem Kontaktpad (12) und der entsprechenden Kontaktfläche (9) zumindest 2500: 1, zumindest 10.000: 1 oder zumindest 30.000:1 ist.

5. Leiterplattenanordnung nach einem vorhergehenden Anspruch, wobei die Dicke, $t$, zwischen $0,1 t_r$ und $10 t_r$ ist, wobei:

$$t_r = \mathrm{sqrt}\ (R_C.A/R_S)$$

wobei $R_C$ Kontaktwiderstand ist und $A$ Bereich der Kontaktfläche (9) und/oder des Kontaktpads (12) ist.

6. Leiterplattenanordnung nach einem vorhergehenden Anspruch, wobei die Verbindungslage (15) in zumindest zwei separate koplanare Pads strukturiert ist.

7. Leiterplattenanordnung nach einem der Ansprüche 1 bis 6, wobei die Mikrosteuerung (3) ein flaches Gehäuse wie ein flaches bleifreies Gehäuse umfasst.

8. Leiterplattenanordnung nach einem der Ansprüche 1 bis 6, wobei die Mikrosteuerung eine Leiterplatte umfasst.

9. Leiterplattenanordnung nach einem vorhergehenden Anspruch, wobei das Substrat (4) flexibel ist.

10. Leiterplattenanordnung nach einem vorhergehenden Anspruch, wobei das Substrat (4) eine Lage aus einem faserbasierten Material wie Papier, Pappe oder Karton umfasst, wobei bevorzugt die Lage hauptsächlich aus dem faserbasierten Material besteht.

11. Leiterplattenanordnung nach einem vorhergehenden Anspruch, wobei das Substrat (4) eine Lage aus einem Kunststoffmaterial umfasst und/oder das Substrat ein Laminat aus zumindest zwei Lagen umfasst.

12. Leiterplattenanordnung nach einem vorhergehenden Anspruch, wobei die Leiterplattenanordnung einen gedruckten Artikel oder Teil eines gedruckten Artikels umfasst, der gedruckte Zeichen trägt.

13. Verfahren zur Herstellung einer Leiterplattenanordnung nach Anspruch 1, wobei das Verfahren Folgendes umfasst:

Aufbringen einer Verbindungslage (15), die einen Schichtwiderstand, Rs, von zumindest 0,5 M$\Omega$/sq aufweist, auf eine Mikrosteuerung (3), die eine Vielzahl von Kontaktpads (12) umfasst, und/oder auf eine Leiterplatte (2), die ein Substrat (4) umfasst, das eine Vielzahl von Bahnen (8) trägt, wobei jede Bahn ein erstes Ende (9), das eine Kontaktfläche (11) bereitstellt, und ein zweites Ende (10) mit einer vergrößerten Region (14), die einen kapazitiven Berührungsschalter bereitstellt, beinhaltet; und

Montieren der Mikrosteuerung auf einer Leiterplatte, sodass die Kontaktpads mit den Kontaktflächen ausgerichtet sind und sodass die Verbindungslage elektrische Verbindungen zwischen den Kontaktflächen und entsprechenden Kontaktpads bereitstellt, wobei die Mikrosteuerung konfiguriert ist, um Benutzereingabe über die kapazitiven Berührungsschalter zu empfangen;

wobei ein Durchgangswiderstand, $R_T$, der Verbindung zwischen den Kontaktflächen und entsprechenden Kontaktpads geringer als der Schichtwiderstand, $R_S$, ist; und

wobei ein Widerstand zwischen benachbarten Kontaktpads aus der Vielzahl von Kontaktpads oder zwischen benachbarten Kontaktflächen aus der Vielzahl von Kontaktflächen größer als der oder gleich dem Schichtwiderstand ist.

## Revendications

1. Ensemble carte à circuit imprimé comprenant :

une carte à circuit imprimé (2) comprenant un substrat (4) supportant une pluralité de pistes (8), chaque piste comprenant une première extrémité (9) fournissant une surface de contact (11) et une seconde extrémité (10) comportant une zone élargie (14) qui fournit un commutateur tactile capacitif ;

un micro-dispositif de commande (3) comprenant une pluralité de plots de contact (12) qui sont montés sur la carte à circuit imprimé de sorte que les plots de contact soient alignés avec les surfaces de contact, le micro-dispositif de commande étant configuré pour recevoir une entrée utilisateur via les commutateurs tactiles capacitifs ; et

une couche d'interconnexion (15) qui comporte une résistance de feuille, Rs, supérieure ou égale à 0,5M$\Omega$/carré et qui est disposée entre le micro-dispositif de commande et la carte à circuit imprimé et qui est agencée pour fournir des connexions électriques entre les surfaces de contact et les plots de contact correspondants ;

une résistance traversante, $R_\tau$, de la connexion entre les surfaces de contact et les plots de contact correspondants étant inférieure à la résistance de feuille, Rs ; et

une résistance entre les plots de contact adjacents de la pluralité de plots de contact ou entre les surfaces de contact adjacentes de la pluralité de surfaces de contact étant supérieure ou égale à la résistance de feuille.

2. Ensemble carte à circuit imprimé selon la revendication 1, la séparation entre les plots de contact (12) ou les surfaces de contact (9) adjacentes étant supérieure ou égale à une largeur de chaque plot de contact ou surface de contact.

3. Ensemble carte à circuit imprimé selon la revendication 1 ou 2, ladite couche d'interconnexion (15) comprenant un matériau conducteur de manière homogène, par exemple un polymère conducteur.

4. Ensemble carte à circuit imprimé selon l'une quelconque des revendications précédentes, le rapport de la résistance de feuille, Rs, à la résistance de contact, $R_C$, entre un plot de contact (12) et la surface de contact correspondante (9) étant supérieur ou égal à 2 500:1, supérieur ou égal à 10 000:1 ou supérieur ou égal à 30 000:1.

5. Ensemble carte à circuit imprimé selon l'une quelconque des revendications précédentes, ladite épaisseur, t, étant comprise entre 0,1.$t_r$ et 10.$t_r$, où :

$$t_r = \sqrt{(R_C.A/R_S)}$$

où $R_C$ représente la résistance de contact et $A$ représente la superficie de la surface de contact (9) et/ou du plot de contact (12).

6. Ensemble carte à circuit imprimé selon l'une quelconque des revendications précédentes, ladite couche d'interconnexion (15) étant structurée en au moins deux plots coplanaires distincts.

7. Ensemble carte à circuit imprimé selon l'une quelconque des revendications 1 à 6, ledit micro-dispositif de commande (3) comprenant un boîtier plat, par exemple un boîtier plat sans fil.

8. Ensemble carte à circuit imprimé selon l'une quelconque des revendications 1 à 6, ledit micro-dispositif de commande comprenant une carte à circuit imprimé.

9. Ensemble carte à circuit imprimé selon l'une quelconque des revendications précédentes, ledit substrat (4) étant souple.

10. Ensemble carte à circuit imprimé selon l'une quelconque des revendications précédentes, ledit substrat (4) comprenant une couche d'un matériau à base de fibres, par exemple du papier, du papier cartonné ou du carton, de préférence ladite couche étant constituée principalement du matériau à base de fibres.

11. Ensemble carte à circuit imprimé selon l'une quelconque des revendications précédentes, ledit substrat (4) comprenant une couche d'une matière plastique et/ou ledit substrat comprenant un stratifié d'au moins deux couches.

12. Ensemble carte à circuit imprimé selon l'une quelconque des revendications précédentes, ledit ensemble de carte de circuit imprimé comprenant un article imprimé ou une partie d'un article imprimé supportant des marques imprimées.

13. Procédé de fabrication d'un ensemble carte à circuit imprimé selon la revendication 1, le procédé comprenant :

l'application d'une couche d'interconnexion (15) qui comporte une résistance de feuille, $R_S$, supérieure ou égale à 0,5 MΩ/carré sur un micro-dispositif de commande (3) comprenant une pluralité de plots de contact (12) et/ou sur une carte à circuit imprimé (2) comprenant un substrat (4) supportant une pluralité de pistes (8), chaque piste comprenant une première extrémité (9) fournissant une surface de contact (11) et une seconde extrémité (10) comportant une zone élargie (14) qui fournit un commutateur tactile capacitif ; et

le montage du micro-dispositif de commande sur une carte à circuit imprimé de sorte que les plots de contact soient alignés avec les surfaces de contact et de sorte que la couche d'interconnexion fournisse des connexions électriques entre les surfaces de contact et les plots de contact correspondants, ledit micro-dispositif de commande étant configuré pour recevoir une entrée utilisateur via les commutateurs tactiles capacitifs ;

une résistance traversante, $R_T$, de la connexion entre les surfaces de contact et les plots de contact correspondants étant inférieure à la résistance de feuille $R_S$ ; et

une résistance entre les plots de contact adjacents de la pluralité de plots de contact ou entre des surfaces de contact adjacentes de la pluralité de surfaces de contact étant supérieure ou égale à la résistance de feuille.

Fig. 1

Fig. 2

12 12 12 12 12 12 12 12

12

12

12

12

12

12

12

12

3

12

12

12

12

12

12

12

12

12 12 12 12 12 12 12 12

## Fig. 3a

3

13

12 12 12 12 12 12 12 12

## Fig. 3b

Fig. 4a

Fig. 4b

Fig. 4c

Fig. 5

**REFERENCES CITED IN THE DESCRIPTION**

**Patent documents cited in the description**

- GB 2464537 A
- WO 2004077286 A
- WO 2007035115 A
- DE 19934312672 A
- US 20050046023 A1
- US 5629838 A
- WO 2008065997 A
- EP 1702968 A1
- EP 0260141 A2
- DE 2902002 A1
- WO 9941784 A1
- GB 2490384 A
- GB 2494223 A
- WO 02061831 A1